(19) **Europäisches Patentamt / European Patent Office / Office européen des brevets**

(11) **EP 4 632 633 A1**

(12) # EUROPEAN PATENT APPLICATION

(43) Date of publication:
**15.10.2025 Bulletin 2025/42**

(21) Application number: **24169676.4**

(22) Date of filing: **11.04.2024**

(51) International Patent Classification (IPC):
**G06N 10/40** $^{(2022.01)}$

(52) Cooperative Patent Classification (CPC):
**G06N 10/40**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Infineon Technologies Austria AG**
**9500 Villach (AT)**

(72) Inventors:
 • **BRANDL, Matthias**
 **85614 Kirchseeon (DE)**

 • **REPP, Jens**
 **85570 Markt Schwaben (DE)**

(74) Representative: **Infineon Patent Department Intellectual Property**
**Infineon Technologies AG**
**Postfach 22 16 44**
**80506 München (DE)**

Remarks:
Amended claims in accordance with Rule 137(2) EPC.

(54) **AN ION TRAP DEVICE**

(57)   An ion trap device in which a return line portion (230) and one or more signal line portions (220), for driving an electrode (210) of the ion trap device, are configured to run alongside one another in close proximity for a majority of the length of the return line portion.

FIG. 2

EP 4 632 633 A1

## Description

### TECHNICAL FIELD

The present disclosure relates to the field of quantum computing, and in particular, to ion trap devices that include electrodes.

### BACKGROUND

There is growing interest and rapid development in the field of quantum computing. One particular type of quantum computing environment is a trapped ion environment, in which computing is performed using ions as qubits for computation. The excitation state of an electron of an ion indicates a logical value or logic state. Ions such as barium (Ba), magnesium (Mg), calcium (Ca), beryllium (Be), or the like, may be positively charged, and a single electron in the outer shell of the ion used as the logic element. Two or more ions may be entangled, as changing the state of one qubit causes the entangled qubits to change their state immediately, having the potential to provide substantial speed and power savings over conventional computing.

Quantum computing requires a well-controlled environment, and precise handling of the ions. Generally, ions in a trapped ion device, also referred to as a trapped ion quantum computing (TIQC) system, are trapped or controlled using electromagnetic fields.

For example, ions may be moved between locations (e.g., storage, processing and readout locations) in a process called ion shuttling. In order to control the ion movement, electrodes are controlled to provide an intended electromagnetic field (EM-field). Therefore, accurate control of the E-fields created by the electrodes in the trapped ion device is desired. For example, it would be advantageous to reduce any noise or other undesired fluctuations of the EM-field experienced by the ion(s), particularly the magnetic component of the EM-field, as the location and movement of the ion(s) may be sensitive even to subtle changes in the EM-field.

### SUMMARY

There is provided an ion trap device comprising a plurality of electrode arrangements, each of the plurality of electrode arrangements comprising: one or more electrodes; one or more signal line portions, each of the one or more signal line portions for carrying a signal voltage for the one or more electrodes; a return line portion, the return line portion for carrying a reference voltage for the one or more electrodes; and for each of the one or more electrodes, a capacitance arrangement connected between the electrode and the return line portion, wherein, for each electrode arrangement, the return line portion and each of the one or more signal line portions run proximate to one another for a majority of the length of the return line portion; and a maximum width of the return line portion is no greater than 10 times the width of any one of the one or more signal line portions.

Those skilled in the art will recognize additional features and advantages upon reading the following detailed description, and upon viewing the accompanying drawings.

### BRIEF DESCRIPTION OF THE DRAWINGS

The present disclosure is illustrated by way of example, and not by way of limitation, in the figures of the accompanying drawings in which like reference numerals refer to similar or identical elements. The elements of the drawings are not necessarily to scale relative to each other. The features of the various illustrated examples can be combined unless they exclude each other.

Fig. 1 illustrates an electrode arrangement used in an existing ion trap device.
Fig. 2 illustrates an electrode arrangement for use in an ion trap device.
Fig. 3 illustrates a plurality of electrode arrangements for use in an ion trap device.
Fig. 4 illustrates another plurality of electrode arrangements for use in an ion trap device.
Fig. 5 illustrates a plurality of electrode arrangements for use in an ion trap device.
Fig. 6 illustrates another electrode arrangement for use in an ion trap device.
Fig. 7 illustrates yet another electrode arrangement for use in an ion trap device.
Fig. 8 illustrates a cross-sectional view of an electrode arrangement.
Fig. 9 illustrates a cross-sectional view of another electrode arrangement.
Fig. 10 illustrates a cross-sectional view of yet another electrode arrangement.

## DETAILED DESCRIPTION

The examples described herein provide an ion trap device. A return line portion and one or more signal line portions, for driving an electrode of the ion trap device, are configured to run alongside one another in close proximity for a majority of the length of the return line portion.

In an ion trap device, also known as a trapped ion quantum circuit (TIQC), there is commonly a desire to control the location of an ion that is being held within a containment region (e.g., by at least an RF system or a static magnetic field). This can be to facilitate movement of the ion between different locations, each designated for the performance of different quantum computing tasks (e.g., storage, processing and/or readout).

Moving an ion in a containment region of an ion trap device typically requires manipulating the electric field that surrounds the ion. Appropriate manipulation of the electric field surrounding the ion can therefore be used to control the location of the ion.

A typical ion trap device or TIQC will control the voltage provided to each of a plurality of electrodes surrounding or bounding the containment region in which the ion is to be held. In other words, electrodes proximate to an ion are typically used to trap and/or move the ion. Typically, each electrode is associated with a corresponding capacitance arrangement, e.g., connected to one side of a capacitance arrangement. More particularly, a respective capacitance arrangement may connect an electrode to a ground or reference voltage.

In some types of TIQC, such as Paul traps, electrodes of the TIQC have to be shunted to a ground or reference voltage, e.g., due to the use of an RF system to hold the ion within a containment region. In such types of TIQC, the capacitance arrangement may comprise a purposively integrated shunt capacitance arrangement, as well as other forms of capacitance (e.g., a parasitic capacitance).

However, in other types of TIQC, such as Penning traps, a capacitance may still be provided to connect between the electrode and the ground or reference voltage. This capacitance may include at least a decoupling or filtering capacitance arrangement, such as one chosen to decrease thermal noise and/or Johnson-Nyquist noise.

To control the voltage at an electrode of a TIQC, it is common for the TIQC to selectively connect one or more signal lines (e.g., signal lines that are connected to a voltage source, such as a digital-to-analog converter) to the electrode. Usually only one signal line is connected to any given electrode at a time. However, a single signal line may be connected to varying number of electrodes at a same time (such as five, ten or even hundreds), depending upon the control scheme for the electrode(s).

Similarly, to provide the ground or reference voltage to which a capacitance arrangement connects, it is common for the TIQC to connect a return line to the capacitance arrangement.

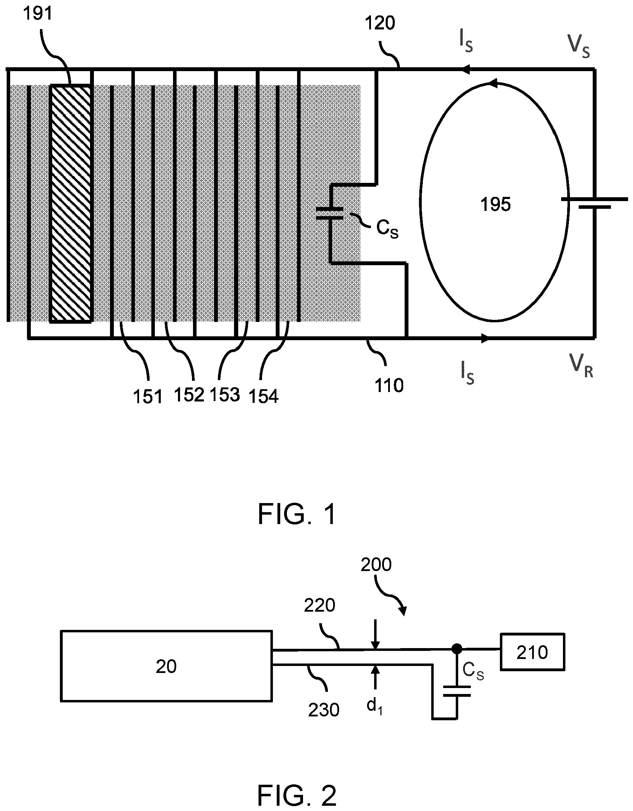

Fig. 1 illustrates an existing approach for providing a signal line 110, providing a signal voltage Vs, and a return line 120, providing a reference voltage $V_R$, for an electrode arrangement. These lines are typically provided (as much as possible) in a single layer of a multilayer structure.

As a general principle, layout design of power circuitry targets the minimization of parasitic, particularly series resistance. Therefore, a common design policy for signal and return lines is to route as much as possible in a single layer and minimize the number of vias. This results in a common structure in which forks are used (as illustrated in Fig. 1) to supply a large area with the signal voltage and reference voltage. Circuitry components 151, 152, 153, 154 connect to the forks to be powered therefrom. In the illustrated example, a capacitance arrangement Cs is one example of a circuitry component. The capacitance arrangement is connected to an electrode (not visible in Fig. 1) that is used for trapping the ion.

The fork-based layout design can create large loops 191, 195 around which current $I_S$ flows. In this context, a loop is a loop of conductive material through which current flows. Naturally, this creates large loops of current, creating a magnetic field that can affect an ion or ion string in the nearby vicinity.

The present disclosure recognizes that it is possible to significantly reduce a magnetic field in the vicinity of an ion (or ion string) controlled by an electrode if part of the signal line (for said electrode) and part of the return line (for the capacitance arrangement connected to said electrode) run in close proximity to one another. In particular, it is recognized that there is a dependence of the magnitude of a magnetic field on the distance between two wires, i.e., a spatial dependence.

In particular, where the magnetic field of a single wire is considered, then the magnitude of the magnetic field (H) at any location (e.g., the location of an ion) is proportional to the reciprocal of the distance $d_L$ between the wire and the location. Thus:

$$H \; \propto \frac{1}{d_L} \hspace{4cm} (1)$$

However, if two wires (having a same width W) are positioned proximate to one another (e.g., separated by no more than a separation distance $d_s$), and the current in each wire flows in directions opposite to each other, then the magnitude of the magnetic field (H) at any location L is proportional to the cube of the distance $d_L$ between the wire(s) and the location as follows:

$$H \propto \frac{W \cdot d_s}{d_L{}^3} \qquad\qquad (2)$$

To achieve a reduction in the magnetic field, then the current density in the two wires (that run proximate to one another) should be similar. This can be achieved by, if both wires (are to) carry a current of a similar magnitude, forming each wire to have a same or similar width.

Thus, the size of the magnetic field at a location, particularly a location of an ion manipulated by the ion trap device, can be significantly reduced if two wires used to provide voltage for manipulating the position of the wire are positioned in close proximity to one another, are of similar widths and by design, the current flows in opposite directions.

For an electrode arrangement of an ion trap device, a signal line will carry the signal for controlling the voltage at an electrode and a return line will act as a return path for this signal. Thus, current in the signal line will pass through to the return line. As a natural consequence, where the signal and return lines connect between two components, current in the signal line flows in the opposite direction to current in the return line.

The present disclosure proposes the use of an electrode arrangement in which each of one or more signal line portions (which each connect to a respective electrode) run in close proximity to a return line portion (which connects to a respective capacitance arrangement connected to each respective electrode) and the return line portion has a width no greater than 10 times the width of any signal line portion. Current in the signal line portion and in the return line portion flows in opposite directions. This significantly reduces, from the perspective of any ion trapped/manipulated by the electrode, the magnetic field induced by the signal voltage carried by the signal line. This may reduce magnetic field noise, e.g., on qubits or ions.

Fig. 2 illustrates an example of an electrode arrangement 200 for use in proposed ion trap devices. The electrode arrangement comprises an electrode 210, a signal line portion 220, a return line portion 230 and a capacitance arrangement Cs.

As previously explained, the electrode 210 is used for trapping an ion and/or controlling/manipulating a position of an ion within the ion trap device. In this way, the electrode can be associated with an ion trapping position, which defines a position at which an ion controlled using any one of the one or more electrodes, is trapped.

The signal line portion 220 carries a signal voltage for the electrode 210. In particular, the signal line portion 220 carries the signal voltage to a first side of the capacitance arrangement Cs. In this way, the signal line portion (directly) connects to the capacitance arrangement.

The return line portion 230 carries a reference voltage for the electrode 210, e.g., a ground voltage or earth. In particular, the return line portion 230 carries the reference voltage to a second side (different to the first side) of the capacitance arrangement. In this way, the return line portion (directly) connects to the capacitance arrangement.

More particularly, the return line portion 230 provides a path through which electrons are able to move away from the electrode 210. Thus, the current flow along the signal line portion(s) flows in an opposite direction (i.e., towards or away from the electrode) to a current flow along the return line portion 230 (i.e., away from or towards the electrode respectively).

The capacitance arrangement Cs is connected between the electrode 210 and the return line portion 230, i.e., between the signal line portion 220 and the return line portion 230.

The signal line portion 220 may form a part of a signal line connecting a signal generator to the electrode. Although not illustrated, the signal generator may comprise a switching network/matrix for controlling signal flow along the signal line portion. The signal line portion 220 may include at least a most proximal (to the electrode) part of this signal line. In the illustrated example, the signal line portion 220 directly connects a signal generator 20 to the electrode 210. Thus, in the illustrated example, the signal line portion represents the entirety of the signal line between the signal generator and the electrode 210. The signal generator 20 generates the signal voltage for the electrode 210. The signal generator 20 may form part of the ion trap device or can be separated from the ion trap device.

Similarly, the return line portion 230 may form a part of a return line connecting a reference voltage (e.g., defined by the signal generator 20) to the electrode. The return line portion 230 may include at least a most proximal (to the electrode) part of this return line. In the illustrated example, the return line portion directly connects a (ground of the) signal generator 20 to the capacitive arrangement Cs. Thus, in the illustrated example, the return line portion here represents the entirety of a return line between the signal generator and the capacitive arrangement Cs. The signal generator 20 may define the reference voltage. In other examples, the return line (portion) connects to a ground or reference voltage, e.g., independent of the signal generator 20.

The return line portion 230 and the signal line portion 220 run proximate to one another for a majority of the length of the return line portion.

In particular examples, a distance $d_1$ between the return line portion and the signal line portion 220 may be less than a predetermined distance for a majority of the length of the return line portion. For instance, a distance between the return line portion and the signal line portion may be no more than $10\mu m$, or no more than $5\mu m$, for a majority of the length of the return line portion.

Thus, in the context of the present disclosure, two elements may run proximate to one another if a distance between the two elements is no less than $10\mu m$, or no more than $5\mu m$.

In the context of the present disclosure, the term "majority" may refer to no less than 50% no less than 75%, or no less than 90%.

In some examples, for each electrode arrangement, at any point along the majority of the length of the return line portion, a first ratio is no greater than 0.5, wherein the first ratio is defined as the ratio between: the shortest distance $d_1$ between the return line portion at said point and the most distant of the one or more signal line portions from said point; and the shortest distance between the return line portion at said point and an ion trapping position controlled using any one of the one or more electrodes connected with the return line portion.

The width of the return line portion is no greater than 10 times (e.g., no greater than 5 times) the width of the signal line portion. For the illustrated example, in which the electrode arrangement comprises only a single return line portion and a single signal line portion, then the widths of the return line portion and the signal line portion may be substantially equal. This significantly reduces a (stray) magnetic field produced by the electrode arrangement.

In the illustrated example, the electrode arrangement comprises a single electrode and a single signal line portion. However, in other examples, the electrode arrangement comprises more than one electrode and/or more than one signal line portion.

For instance, in some examples, the electrode arrangement comprises a plurality of electrodes, each with an associated signal line portion. The signal line portion for each electrode is configured to run proximate to the return line portion for a majority of the length of the return line portion. A more complete example of this approach is provided later in this disclosure.

As another example, the electrode arrangement may comprise a plurality of signal line portions for a single electrode. Each signal line portion electrode is configured to run proximate to the return line portion for a majority of the length of the return line portion. A more complete example of this approach is provided later in this disclosure.

As another example, the electrode arrangement may comprise a plurality of electrodes, each with an associated group of two or more signal line portions. The signal line portions for each electrode arrangement are configured to run proximate to the return line portion of said electrode arrangement for a majority of the length of the return line portion.

In any such example, the width of the return line portion is no greater than 10 times (e.g., no greater than 5 times) the width of any signal line portion of the same electrode arrangement.

For improved effectiveness of reducing the magnetic field noise in the vicinity of any trapped ion(s), for each electrode arrangement, in the vicinity of the one or more electrodes, the return line portion is distanced (e.g., by no less than $1\mu m$) from the return line portion of each other electrode arrangement. This helps ensure that the (opposite direction) current density flow in the vicinity of each signal line portion is substantially the same, e.g., less affected by current flow in other return line portions of other electrode arrangements.

Effectively, this approach means that there may be a minimum distance between the return line portions of different electrode arrangements at the point at which they terminate with respect to the corresponding electrode(s), i.e., in the vicinity of the corresponding electrode(s). For instance, if the return line portion terminates at a capacitance arrangement for each electrode, then this may effectively mean that there is a minimum distance (e.g., no less than $1\mu m$ between any capacitance arrangement of different electrode arrangements).

In some examples, for each electrode arrangement, the vicinity of the one or more electrodes comprises a sphere, centered at the one or more electrodes, having a radius of no less than 500nm and no more than $5\mu m$.

For instance, the vicinity of the one or more electrodes may be defined as a space occupied by a respective sphere centered at each electrode of the electrode arrangement, having a radius of no less than 500nm and no more than $5\mu m$.

Thus, in this embodiment, any part of the return line portion (of a respective electrode arrangement) that lies within a certain distance (e.g., which certain distance may be within a range of from 500nm to $5\mu m$) of any electrode of the respective electrode arrangement may be distanced (e.g., by a minimum distance such as $1\mu m$) from any return line portion of any other electrode arrangement.

Put another way, if a two-dimensional cross-section of the ion device is taken at any angle, then any part of a return line portion (of a respective electrode arrangement) that lies within a certain distance of the electrode of the respective electrode arrangement (within said two-dimensional cross-section) may be distanced (e.g., by a minimum distance such as $1\mu m$) from any return line portion of any other electrode arrangement.

Other suitable ranges for the size of the sphere defining a vicinity of an electrode and/or the certain distance mentioned above are considered. For instance, this range, rather than being from 500nm to $5\mu m$, may instead be: from 500nm to $4\mu m$; from 500nm to $3\mu m$; from 500nm to $2\mu m$; from $1\mu m$ to $5\mu m$; from $1\mu m$ to $4\mu m$; from $1\mu m$ to $3\mu m$; from $1\mu m$

to 2μm; from 2μm to 5μm; from 2μm to 4μm; or from 2μm to 3μm. Other suitable examples will be apparent to the skilled person.

Other suitable examples of a minimum distance (for which any part of the return line portion in the vicinity of an electrode of an electrode arrangement is distanced from the return line portion of any other electrode arrangement) are considered. Suitable example distances include: 500nm; 1.5μm; 2μm and so on. Larger distances improve the effectiveness of reducing the magnetic field noise in the vicinity of any trapped ion. Smaller distances increase an ease of routing signals to the electrode(s) and faciliate a more compact ion trap device.

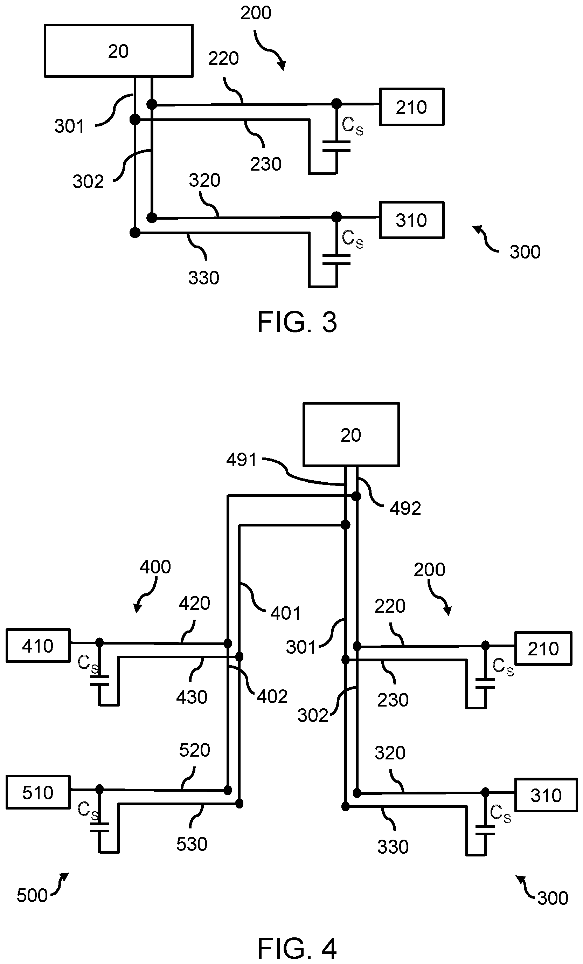

Fig. 3 illustrates a portion of an ion trap device comprising a plurality of electrode arrangements 200, 300. Each electrode arrangement is embodied as previously described.

Thus, there is a first electrode arrangement 200 comprising an electrode 210, a signal line portion 220, a return line portion 230 and a capacitance arrangement Cs. Similarly, there is a second electrode arrangement 300 comprising an electrode 310, a signal line portion 320, a return line portion 330 and a capacitance arrangement Cs.

For each electrode arrangement, the return line portion and the signal line portion run proximate to one another for a majority of the length of the return line portion.

In illustrated example, the return line portion 230, 330 of each electrode arrangement 200, 300 connects to a same shared return line portion 301. More particularly, each return line portion 230, 330 connects between the shared return line portion 301 and its respective capacitance arrangement. The shared return line portion 301 carries or provides the reference voltage for each return line portion 230, 330.

In this way, there is provided a set of electrode arrangements 200, 300. The set of electrode arrangements 200, 300 comprises a shared return line portion 301 for providing the reference voltage to the return line portion 230, 330 of each electrode arrangement 210, 310 in the set of electrode arrangements 200, 300.

In this way, a return line between a reference voltage and the capacitance of any electrode arrangement may comprise at least a shared return line portion 301 and a return line portion 230 (or 330). The shared return line portion 301 may connect to two or more return line portions 230, 330.

Similarly, in the illustrated example, the signal line portion 220, 320 of each electrode arrangement 200, 300 connects to a same shared signal line portion 302. Thus, each signal line portion 220, 330 of each electrode arrangement (in the set of electrode arrangements 200, 300) connects between the capacitance arrangement of said electrode arrangement and the shared signal line portion 302.

Thus, in this approach, the signal line and return line are formed from a respective line portion (for each electrode arrangement) and a respective additional portion.

For further reduction in the magnetic field noise, the shared return line portion 301 and the/each shared signal line portion 230 (or 330) may run alongside proximate to one another for a majority of the length of the shared return line portion (301). A definition for how two elements may run proximate to one another (e.g., as defined by distance) has been previously provided.

In preferred examples, the width of the shared return line portion is no greater than 10 times (e.g., no greater than 5 times) the width of any shared signal line portion that runs alongside said shared return line portion.

In the illustrated example, each electrode arrangement comprises a single signal line portion, which connects to a same shared signal line portion (for the set of electrode arrangements). In other examples, e.g., where each electrode arrangement comprises multiple signal line portions (e.g., that run alongside the same shared return line portion), then different signal line portions of a same electrode arrangement may connect to different shared signal portions (of the set of electrode arrangements).

Fig. 4 illustrates a portion of an ion trap device comprising a plurality of electrode arrangements 200, 300, 400, 500. Each electrode arrangement is embodied as previously described.

In the illustrated example, there are two sets of electrode arrangements. A first set of electrode arrangements 200, 300, comprises a first 200 and second 300 electrode arrangement. A second set of electrode arrangements comprises a third 400 and fourth 500 electrode arrangement. Each set of electrode arrangement comprises a respective shared return line portion 301, 401. In particular, the first set of electrode arrangements comprises a first shared return line portion 301 (which connects to the return line portion in each electrode arrangement in the first set of electrode arrangements). Similarly, the second set of electrode arrangements comprises a second shared return line portion 401 (which connects to the return line portion in each electrode arrangement in the second set of electrode arrangements).

It is therefore possible to define a group of electrode arrangements 200, 300, 400, 500. The group of electrode arrangements comprises two or more sets of electrode arrangements. In the illustrated example, only a single group of electrode arrangements is illustrated, but it will be appreciated that the group may define more than one group.

The/each group of electrode arrangements comprises a common return line portion 491 for providing a reference voltage for the shared return line portion 301, 401 of each set of electrode arrangements in said group of electrode arrangements.

Of course, it will therefore be appreciated that (for each group of electrode arrangements) the shared return line portion 301, 401 of each set of electrode arrangements in the group of electrode arrangements, connects to the common return line portion of said group of electrode arrangements. In this way, each shared return line portion (in a group of electrode arrangements) connects between the common return line portion (of the group of electrode arrangements) and two or more return line portions (in the group of electrode arrangements).

In this way, a return line between a reference voltage and the capacitance of any electrode arrangement may comprise at least a common return line portion, a shared return line portion and a return line portion. The shared return line portion may connect to two or more return line portions. The common return line portion may connect to two or more shared return line portions.

Similarly, a respective shared signal line portion of each set of electrode arrangements may connect to a same common signal line portion. In particular, each set of electrode arrangements may comprise one or more shared signal line portions (in the illustrated example: a single signal line portion). A common signal line portion may connect to a respective shared signal line portion of each electrode arrangement.

For reduced magnetic field noise, the common return line portion and the/each common signal line portion may run alongside proximate to one another for a majority of the length of the common return line portion. A definition for how two elements may run proximate to one another (e.g., as defined by distance) has been previously provided.

In preferred examples, the width of the common return line portion is no greater than 10 times (e.g., no greater than 5 times) the width of any common signal line portion that runs alongside said common return line portion.

In this way, a star-like or tree structure can define the connection of a reference voltage to the capacitance arrangement of each electrode arrangement. In particular, an electrical connection between a reference voltage and each capacitance arrangement is provided using a physical tree-structure. In particular, a connection may branch or split at one or more different nodes before reaching the capacitance arrangement. Thus, each part of the return line branches from a previous part of the return line without creating a loop in the return line. In this way, for each electrode arrangement, there is a single path between the reference voltage and the capacitance arrangement of the electrode arrangement (i.e., and no loops).

Put another way, a reference voltage may be connected to the capacitance arrangement of each electrode arrangement via a branching structure. In particular, each capacitance arrangement may connect to the reference voltage via a unique branch of the branching structure.

Thus, in some embodiments, the ion trap device comprises a return line arrangement formed from a branching structure that connects a reference voltage to each return line portion. The branching structure of the return line arrangement may be configured such, for each return line portion, that there is a single path between the reference voltage and the return line portion (i.e., and no loops).

A similar approach may be adopted for the signal line portions. In particular, the ion trap device may comprise one or more signal line arrangements each formed from a respective branching structure that connects an output of a signal generator to two or more signal line portions. Each branching structure of the signal line arrangement may be configured such, for each signal line portion, that there is a single path between the respective signal generator(s) and the signal line portion (i.e., and no loops).

In embodiments, each signal line may run proximate to a/the return line for a majority of the return line or signal line. In this way, each part of the branching structure of each signal line arrangement may run proximate to a corresponding part of the branching structure of a return line arrangement. The previously mentioned line portions, shared line portions and common line portions are examples of parts of such branching structures.

Of course, the ion trap device may, in practice, comprise more than return line arrangement.

In the embodiment illustrated by Fig. 4, each return line portion connects to a shared return line portion that in turn connects to a common return line portion. It will be appreciated that, in some embodiments, a return line portion of an electrode arrangement may connect directly to a common return line portion. Thus, the ion trap device may comprise a plurality of electrode arrangements, for which some return line portions may connect to a common return line portion via one or more shared return line portions and for which at least one other return line portion connects directly to the common return line portion.

It will also be appreciated that a common return line portion may, in turn, connect to a further common return line portion (e.g., to which multiple common return line portions connect).

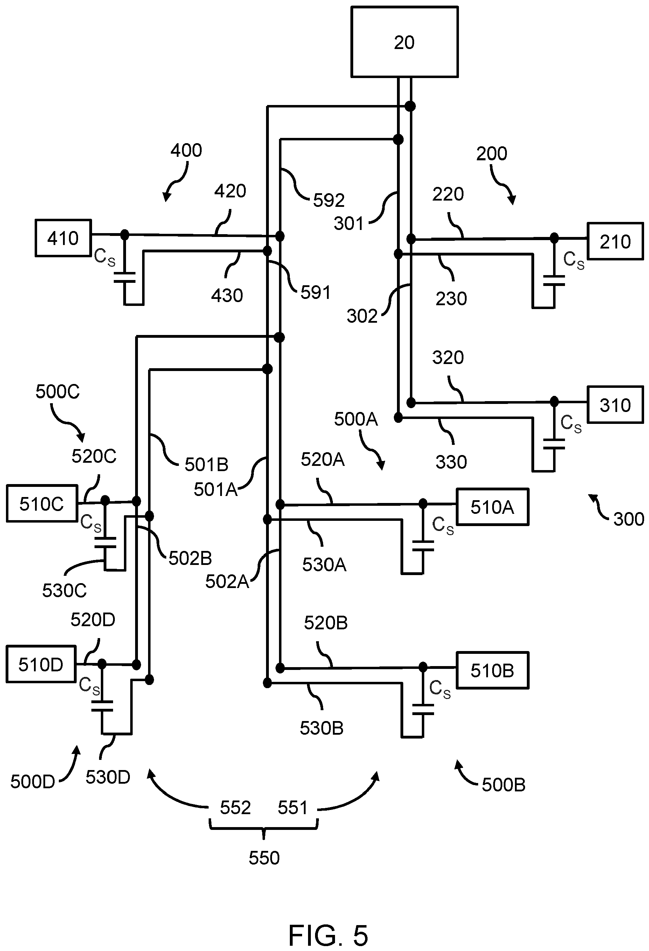

Fig. 5 illustrates a portion of an ion trap device comprising a plurality of electrode arrangements 200, 300, 400, 500A, 500B, 500C, 500D. Each electrode arrangement is embodied as previously described.

This approach illustrates a further embodiment that employs the same principles of using a branching structure for the return line and/or signal line(s).

Thus, each electrode arrangement 200, 300, 400, 500A, 500B, 500C, 500D comprises an electrode 210, 310, 410, 510A, 510B, 510C, 510D, a signal line portion 220, 320, 420, 520A, 520B, 520C, 520D a return line portion 230, 330, 430, 530A, 530B, 530C, 530D and a capacitance arrangement Cs.

The electrode arrangements comprise a group 550 of two sets 551, 552 of electrode arrangement. In each set 551, 552 the return line portions 530A, 530B, 530C, 530D connect to a same shared return line portion 501A, 501B. Thus, as there are two sets 551, 552, there are two shared return line portions 501A, 501B. In the group 550, the shared return line portions 501A, 501B connect to a same common return line portion 591.

Similarly, in each set 551, 552 the signal line portions 520A, 520B, 530C, 530D connect to a same shared return line portion 502A, 502B. In the group 550, the shared signal line portions 502A, 502B connect to a same common signal line portion 592.

The common return line portion and each common signal line portion may run alongside proximate to one another for a majority of the length of the common return line portion.

As illustrated in Fig. 5, the return line portions 230, 330, 430 of other electrode arrangements 200, 300, 400 may connect to the common return line portion either directly (e.g., like the electrode arrangement 400) or via another shared return line portion 301 (e.g., like the electrode arrangements 200, 300).

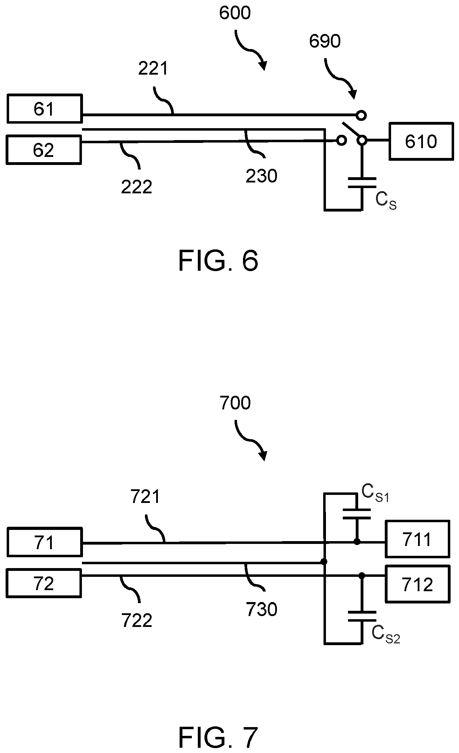

Fig. 6 illustrates another example of an electrode arrangement 600 for use in proposed ion trap devices. The electrode arrangement 600 comprises an electrode 610, a first signal line portion 221, a second signal line portion 222, a return line portion 230 and a capacitance arrangement Cs.

The electrode arrangement 600 provides an example of an approach in which the electrode arrangement comprises more than one signal line portion. In the illustrated example, each signal line portion carries a respective signal voltage generated by a respective signal generator 61, 62 for the electrode 610. A switching arrangement 690 controls which signal line portion connected to the electrode 610.

The electrode arrangement 600 is configured such that each signal line portion runs proximate to the return line portion for a majority of the length of the return line portion. In this way, multiple signal line portions of the electrode arrangement may run proximate to the return line portion.

Fig. 7 illustrates another example of an electrode arrangement 700 for use in proposed ion trap devices. The electrode arrangement 700 comprises a first electrode 711, a second electrode 712, a first signal line portion 721, a second signal line portion 722, a return line portion 730 and, for each electrode 711, 712, a capacitance arrangement $Cs_1$, $Cs_2$.

The electrode arrangement 700 provides an example of an approach in which the electrode arrangement comprises more than one electrode. In the illustrated example, each electrode is connected to a respective signal line portion 721, 722 that carries a respective signal voltage generated by a respective signal generator 71, 72 for the electrode. Thus, the first electrode is connected to a first signal line portion 721 and the second electrode is connected to a second signal line portion 722.

The electrode arrangement 700 is configured such that each signal line portion runs proximate to the return line portion for a majority of the length of the return line portion. In this way, multiple signal line portions of the electrode arrangement may run proximate to the return line portion.

Figs. 6 and 7 illustrate examples in which an electrode arrangement comprises more than one signal line portion. It will be readily appreciated how the signal line portions may connect to (e.g., a respective) shared signal line and/or a common signal line (as well as further branches of a connecting tree).

It has previously been explained how an electrode arrangement may comprise a return line portion and one or more signal line portions.

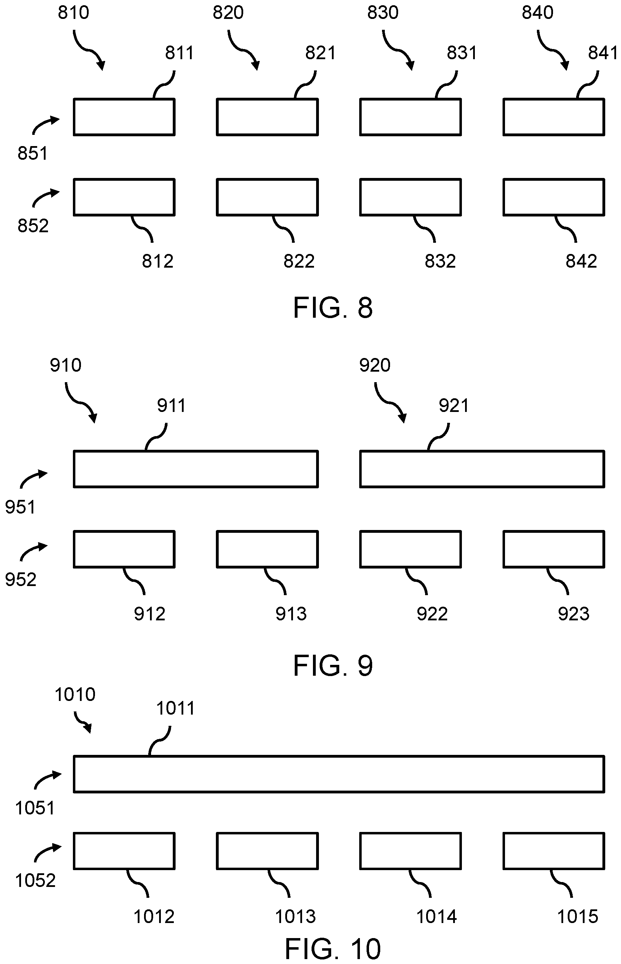

Fig. 8 provide a partial cross-sectional illustration of an ion trap device embodying an approach in which each of a plurality of electrode arrangements 810, 820, 830, 840 comprise a return line portion 811, 821, 831, 841 and a single signal line portion 812, 822, 832, 842. In this approach, each single signal line portion runs proximate to the return line portion of the same electrode arrangement.

In particular, the ion trap device may comprise a multilayer stack, wherein, for each electrode arrangement, the return line portion and the signal line portion are located in the multilayer stack. More specifically, for each electrode arrangement, the return line portion is provided in a different layer of the multilayer stack with respect to the signal line portion. Thus, for each electrode arrangement, the return line portion may be provided in a first layer 851 and the signal line portion is provided in a second (different) layer 852.

Although illustrated in Fig. 8, it is not necessary that all signal line portions of the ion trap device are in the same layer and all return line portions are in a different layer. It could be also possible, for instance, that one signal line portion 812 of a first electrode arrangement is a first layer, with a corresponding return line portion 811 of the first electrode arrangement lying in a second layer, whereas a different signal portion 822 of a second electrode arrangement may lie in the second layer with the corresponding return line portion 821 of the second electrode arrangement lying in the first layer.

Other variations and designs will be apparent to the appropriately skilled person. For instance, the signal line portions of different electrode arrangements may be variously arranged in different layers of the multilayer stack.

However, it has been identified that providing the return line portion and signal line portion of a same electrode arrangement in different layers further reduces the magnetic field noise at an ion trapping position.

As illustrated in Fig. 8, for each electrode arrangement, a maximum width of the return line portion is no greater than 10 times the width of any one of the one or more signal line portions. In the illustrated example, the width of each return line portion is the same as the width of the corresponding signal line portion.

Fig. 9 provides a partial cross-sectional illustration of an ion trap device embodying an approach in which each of a plurality of electrode arrangements 910, 920 comprises a return line portion 911, 921 and two signal line portion 912, 913, 922, 923. In this approach, each single signal line portion of an electrode arrangement runs proximate to the return line portion of the same electrode arrangement.

In particular, the ion trap device again comprises a multilayer stack, wherein, for each electrode arrangement, the return line portion and each signal line portion are located in the multilayer stack. More specifically, for each electrode arrangement, the return line portion is provided in a different layer of the multilayer stack with respect to each signal line portion. The signal line portions may lie in a same layer of the multilayer stack. Thus, in the illustrated example, for each electrode arrangement, the return line portion 911, 921 is provided in a first layer 951 and each signal line portion 912, 913, 922, 923 is provided in a second (different) layer 952.

However, it is not necessary that all signal line portions are in the same layer and all return line portions are in a different layer.

For instance, that the signal line portions 912, 913 of a first electrode arrangement 910 lie in a first layer, with a corresponding return line portion 913 of the first electrode arrangement 910 lying in a second layer, whereas the signal portions 922, 923 of a second electrode arrangement 920 may lie in the second layer, with a corresponding return line portion 921 of the second electrode arrangement 920 lying in the first layer. Other variations and designs will be apparent to the appropriately skilled person.

It is similarly not essential that all signal line portions of a same electrode arrangement lie in a same layer (of a multilayer stack). For instance, in some variants, a first signal line portion 912 of an electrode arrangement 910 may lie in a first layer, the return line portion 911 of the electrode arrangement 910 may lie in a second, different layer and a second signal line portion 913 of the electrode arrangement 910 may lie in a third, different layer. The first layer may be stacked on the second layer, and the second layer may be stacked on the third layer.

As illustrated in Fig. 9, for each electrode arrangement, a maximum width of the return line portion is no greater than 10 times the width of any one of the one or more signal line portions. In the illustrated example, the width of each return line portion is less than three times the width of the corresponding signal line portion.

Fig. 10 provides a partial cross-sectional illustration of an ion trap device embodying an approach in which each an electrode arrangement 1010 comprises a return line portion 1011 and four signal line portion 1012, 1013, 1014, 1015. In this approach, each single signal line portion of an electrode arrangement runs proximate to the return line portion of the same electrode arrangement.

In particular, the ion trap device again comprises a multilayer stack, wherein, for each electrode arrangement, the return line portion and each signal line portion are located in the multilayer stack. More specifically, for each electrode arrangement, the return line portion is provided in a different layer of the multilayer stack with respect to each signal line portion. The signal line portions may lie in a same layer of the multilayer stack. Thus, in the illustrated example, for each electrode arrangement, the return line portion 1011 is provided in a first layer 1051 and each signal line portion 1012, 1013, 1014, 1015 is provided in a second (different) layer 1052.

However, it is not essential that all signal line portions of a same electrode arrangement lie in a same layer (of a multilayer stack). For instance, in some variants, a first set of one or more signal line portions of an electrode arrangement may lie in a first layer, the return line portion of the electrode arrangement may lie in a second, different layer and a second set of one or more signal line portions of the electrode arrangement may lie in a third, different layer. The first layer may be stacked on the second layer, and the second layer may be stacked on the third layer.

As illustrated in Fig. 10, for each electrode arrangement, a maximum width of the return line portion is no greater than 10 times the width of any one of the one or more signal line portions. In the illustrated example, the width of each return line portion is less than three times the width of the corresponding signal line portion.

From the foregoing, it will be clear that each electrode arrangement may comprise a plurality of signal line portions. Preferably, for each electrode arrangement, the electrode arrangement comprises no more than 12 electrodes.

In the approaches illustrated by Figs. 8, 9 and 10, the return line portion and each signal line portion are located in different layers of a multilayer stack. However, this is not essential. In other examples, for each electrode arrangement, the return line portion is provided in a same layer of the multilayer stack as the one or more signal line portions. This can increase an ease of routing a return line portion and signal line portion in close proximity to one another.

In addition to the above-described examples, the following examples are disclosed.

Example 1. An ion trap device comprising a plurality of electrode arrangements each of the plurality of electrode arrangements comprising: one or more electrodes; one or more signal line portions, each of the one or more signal line portions for carrying a signal voltage for the one or more electrodes; a return line portion, the return line portion for carrying a reference voltage for the one or more electrodes; and for each of the one or more electrodes, a capacitance arrangement connected between the electrode and the return line portion, wherein, for each electrode arrangement, the return line portion and each of the one or more signal line portions run proximate to one another for a majority of the length of the return line portion; and a maximum width of the return line portion is no greater than 10 times the width of any one of the one or more signal line portions.

Example 2. The ion trap device of example 1, wherein, for each electrode arrangement, in the vicinity of the one or more electrodes, the return line portion is distanced from the return line portion of each other electrode arrangement.

Example 3. The ion trap device of example 2, wherein, for each electrode arrangement, in the vicinity of the one or more electrodes, the return line portion is distanced from the return line portion of each other electrode arrangement by no less than $1\mu m$.

Example 4. The ion trap device of any of examples 2 or 3, wherein, for each electrode arrangement, the vicinity of the one or more electrodes comprises a sphere, centered at the one or more electrodes, having a radius of no less than 500nm and no more than $5\mu m$.

Example 5. The ion trap device of any one of examples 1 to 4, wherein, for each electrode arrangement, a distance between the return line portion and each of the one or more signal line portions is no more than $10\mu m$ for a majority of the length of the return line portion.

Example 6. The ion trap device of any one of examples 1 to 5, wherein, for each electrode arrangement, a distance between the return line portion and each of the one or more signal line portions is no more than $5\mu m$ for a majority of the length of the return line portion.

Example 7. The ion trap device of any one of examples 1 to 6, wherein, for each electrode arrangement, at any point along the majority of the length of the return line portion, a first ratio is no greater than 0.5, wherein the first ratio is defined as the ratio between:

the shortest distance between the return line portion at said point and the most distant of the one or more signal line portions from said point; and

the shortest distance between the return line portion at said point and an ion trapping position controlled using any one of the one or more electrodes connected with the return line portion.

Example 8. The ion trap device of any one of examples 1 to 7, wherein, for each electrode arrangement, the electrode arrangement comprises no more than 12 electrodes.

Example 9. The ion trap device of any one of examples 1 to 8, wherein, for each electrode arrangement, the electrode arrangement comprises a single electrode.

Example 10. The ion trap device of any one of examples 1 to 9, wherein the plurality of electrode arrangements comprises one or more sets of electrode arrangements wherein:

each set of electrode arrangements comprises a shared return line portion for providing a reference voltage for the return line portion of each electrode arrangement in said set of electrode arrangements; and
for each set of electrode arrangements, the return line portion of each electrode arrangement in the set of electrode arrangements connects between the capacitance arrangement of said electrode arrangement and the shared return line.

Example 11. The ion trap device of example 10, wherein:

each set of electrode arrangements comprises one or more shared signal line portions for carrying a signal voltage to a respective signal line portion;
for each set of electrode arrangements, each signal line portion of each electrode arrangement in the set of electrode arrangements connects between the capacitance arrangement of said electrode arrangement and a respective one of the one or more shared signal line portions; and
the shared return line portion and each shared signal line portion run alongside proximate to one another for a majority of the length of the shared return line portion.

Example 12. The ion trap device of example 10 or 11, wherein:

the one or more sets of electrode arrangements comprises two or more sets of electrode arrangements;
the plurality of electrode arrangements comprises one or more groups of electrode arrangements, wherein each group of electrode arrangement comprises two or more of the sets of electrode arrangements;
each group of electrode arrangements comprises a common return line portion for providing a reference voltage for the shared return line portion of each set of electrode arrangements in said group of electrode arrangements; and
for each group of electrode arrangements, the shared return line portion, of each set of electrode arrangements in the group of electrode arrangements, connects to the common return line portion of said group of electrode arrangements.

Example 13. The ion trap device of any one of examples 1 to 12, comprising a multilayer stack, wherein, for each electrode arrangement, the return line portion and each signal line portion is located in the multilayer stack.

Example 14. The ion trap device of example 13, wherein, for each electrode arrangement, the return line portion is provided in a different layer of the multilayer stack with respect to the one or more signal line portions.

Example 15. The ion trap device of example 13, wherein, for each electrode arrangement, the return line portion is provided in a same layer of the multilayer stack as the one or more signal line portions.

Example 16. The ion trap device of any of examples 1 to 15, wherein, for each electrode arrangement, the majority of the length of the return line portion is no less than 90% of the length of the return line portion.

Example 17. The ion trap device of any of examples 1 to 16, wherein each electrode arrangement further comprises one or more switching devices for controlling a connection between each signal line portion and the electrode.

Example 18. The ion trap device of any of examples 1 to 17, further comprising at least one signal generator for generating the respective signal voltage for each signal line portion of each electrode arrangement.

Although specific examples have been illustrated and described herein, it will be appreciated by those of ordinary skill in the art that a variety of alternate and/or equivalent implementations may be substituted for the specific examples shown and described without departing from the scope of the present invention. This application is intended to cover any adaptations or variations of the specific examples discussed herein. Therefore, it is intended that this invention be limited only by the claims and the equivalents thereof.

It should be noted that the methods and devices including its preferred embodiments as outlined in the present document may be used stand-alone or in combination with the other methods and devices disclosed in this document. In addition, the features outlined in the context of a device are also applicable to a corresponding method, and vice versa. Furthermore, all aspects of the methods and devices outlined in the present document may be arbitrarily combined. In particular, the features of the claims may be combined with one another in an arbitrary manner.

It should be noted that the description and drawings merely illustrate the principles of the proposed methods and systems. Those skilled in the art will be able to implement various arrangements that, although not explicitly described or shown herein, embody the principles of the invention and are included within its spirit and scope. Furthermore, all examples and embodiments outlined in the present document are principally intended expressly to be only for explanatory purposes to help the reader in understanding the principles of the proposed methods and systems. Furthermore, all statements herein providing principles, aspects, and embodiments of the invention, as well as specific examples thereof, are intended to encompass equivalents thereof.

## Claims

1. An ion trap device comprising a plurality of electrode arrangements (200, 300, 400, 500, 600), each of the plurality of electrode arrangements comprising:

   one or more electrodes (210, 310, 410, 510);
   one or more signal line portions (220, 221, 222, 320, 420, 520), each of the one or more signal line portions for carrying a signal voltage for the one or more electrodes;
   a return line portion (230, 330, 430, 530), the return line portion for carrying a reference voltage for the one or more electrodes; and
   for each of the one or more electrodes, a capacitance arrangement (Cs) connected between the electrode and the return line portion,
   wherein, for each electrode arrangement:

   the return line portion and each of the one or more signal line portions run proximate to one another for a majority of the length of the return line portion; and
   a maximum width of the return line portion is no greater than 10 times the width of any one of the one or more signal line portions.

2. The ion trap device of claim 1, wherein, for each electrode arrangement, in the vicinity of the one or more electrodes, the return line portion is distanced from the return line portion of each other electrode arrangement.

3. The ion trap device of claim 2, wherein, for each electrode arrangement, in the vicinity of the one or more electrodes, the return line portion is distanced from the return line portion of each other electrode arrangement by no less than $1\mu m$.

4. The ion trap device of any of claims 2 or 3, wherein, for each electrode arrangement, the vicinity of the one or more electrodes comprises a sphere, centered at the one or more electrodes, having a radius of no less than 500nm and no more than $5\mu m$.

5. The ion trap device of any one of claims 1 to 4, wherein, for each electrode arrangement, a distance between the return line portion and each of the one or more signal line portions is no more than 10$\mu$m for a majority of the length of the return line portion.

6. The ion trap device of any one of claims 1 to 5, wherein, for each electrode arrangement, a distance ($d_1$) between the return line portion and each of the one or more signal line portions is no more than 5 $\mu$m for a majority of the length of the return line portion.

7. The ion trap device of any one of claims 1 to 6, wherein, for each electrode arrangement, at any point along the majority of the length of the return line portion, a first ratio is no greater than 0.5, wherein the first ratio is defined as the ratio between:

the shortest distance between the return line portion at said point and the most distant of the one or more signal line portions from said point; and
the shortest distance between the return line portion at said point and an ion trapping position controlled using any one of the one or more electrodes connected with the return line portion.

8. The ion trap device of any one of claims 1 to 7, wherein, for each electrode arrangement, the electrode arrangement comprises no more than 12 electrodes.

9. The ion trap device of any one of claims 1 to 8, wherein, for each electrode arrangement, the electrode arrangement comprises a single electrode.

10. The ion trap device of any one of claims 1 to 9, wherein the plurality of electrode arrangements comprises one or more sets of electrode arrangements wherein:

each set of electrode arrangements comprises a shared return line portion for providing a reference voltage for the return line portion of each electrode arrangement in said set of electrode arrangements; and
for each set of electrode arrangements, the return line portion (230, 330, 430, 530) of each electrode arrangement in the set of electrode arrangements connects between the capacitance arrangement of said electrode arrangement and the shared return line (301, 401).

11. The ion trap device of claim 10, wherein:

each set of electrode arrangements comprises one or more shared signal line portions for carrying a signal voltage to a respective signal line portion;
for each set of electrode arrangements, each signal line portion (220, 320, 420, 520) of each electrode arrangement in the set of electrode arrangements connects between the capacitance arrangement of said electrode arrangement and a respective one of the one or more shared signal line portions; and
the shared return line portion and each shared signal line portion run alongside proximate to one another for a majority of the length of the shared return line portion.

12. The ion trap device of claim 10 or 11, wherein:

the one or more sets of electrode arrangements comprises two or more sets (551, 552) of electrode arrangements (500A, 500B, 500C, 500D);
the plurality of electrode arrangements comprises one or more groups (550) of electrode arrangements, wherein each group of electrode arrangement comprises two or more of the sets (551, 552) of electrode arrangements;
each group of electrode arrangements comprises a common return line portion (591) for providing a reference voltage for the shared return line portion (501A, 501B) of each set of electrode arrangements in said group of electrode arrangements; and
for each group of electrode arrangements, the shared return line portion, of each set of electrode arrangements in the group of electrode arrangements, connects to the common return line portion of said group of electrode arrangements.

13. The ion trap device of any one of claims 1 to 12, comprising a multilayer stack, wherein, for each electrode arrangement, the return line portion and each signal line portion is located in the multilayer stack.

14. The ion trap device of claim 13, wherein, for each electrode arrangement, the return line portion is provided in a different layer of the multilayer stack with respect to the one or more signal line portions.

15. The ion trap device of claim 13, wherein, for each electrode arrangement, the return line portion is provided in a same layer of the multilayer stack as the one or more signal line portions.

16. The ion trap device of any of claims 1 to 15, wherein, for each electrode arrangement, the majority of the length of the return line portion is no less than 90% of the length of the return line portion.

17. The ion trap device of any of claims 1 to 16, wherein each electrode arrangement further comprises one or more switching devices for controlling a connection between each signal line portion and the electrode.

18. The ion trap device of any of claims 1 to 17, further comprising at least one signal generator (20, 61, 62, 71, 72) for generating the respective signal voltage for each signal line portion of each electrode arrangement.

**Amended claims in accordance with Rule 137(2) EPC.**

1. An ion trap device comprising a plurality of electrode arrangements (200, 300, 400, 500, 600), each of the plurality of electrode arrangements comprising:

   one or more electrodes (210, 310, 410, 510);
   one or more signal line portions (220, 221, 222, 320, 420, 520), each of the one or more signal line portions for carrying a signal voltage for the one or more electrodes;
   a return line portion (230, 330, 430, 530), the return line portion for carrying a reference voltage for the one or more electrodes; and
   for each of the one or more electrodes, a capacitance arrangement ($C_S$) connected between the electrode and the return line portion,
   wherein, for each electrode arrangement:

   the return line portion and each of the one or more signal line portions run proximate to one another for a majority of the length of the return line portion; and
   a maximum width of the return line portion is no greater than 10 times the width of any one of the one or more signal line portions,
   wherein a current flow along each signal line portion flows in an opposite direction to a current flow along the return line portion.

2. The ion trap device of claim 1, wherein, for each electrode arrangement, in the vicinity of the one or more electrodes, the return line portion is distanced from the return line portion of each other electrode arrangement.

3. The ion trap device of claim 2, wherein, for each electrode arrangement, in the vicinity of the one or more electrodes, the return line portion is distanced from the return line portion of each other electrode arrangement by no less than 1 $\mu$m.

4. The ion trap device of any of claims 2 or 3, wherein, for each electrode arrangement, the vicinity of the one or more electrodes comprises a sphere, centered at the one or more electrodes, having a radius of no less than 500nm and no more than 5 $\mu$m.

5. The ion trap device of any one of claims 1 to 4, wherein, for each electrode arrangement, a distance between the return line portion and each of the one or more signal line portions is no more than 10 $\mu$m for a majority of the length of the return line portion.

6. The ion trap device of any one of claims 1 to 5, wherein, for each electrode arrangement, a distance ($d_1$) between the return line portion and each of the one or more signal line portions is no more than 5 $\mu$m for a majority of the length of the return line portion.

7. The ion trap device of any one of claims 1 to 6, wherein, for each electrode arrangement, at any point along the majority of the length of the return line portion, a first ratio is no greater than 0.5, wherein the first ratio is defined as the ratio between:

the shortest distance between the return line portion at said point and the most distant of the one or more signal line portions from said point; and

the shortest distance between the return line portion at said point and an ion trapping position controlled using any one of the one or more electrodes connected with the return line portion.

8. The ion trap device of any one of claims 1 to 7, wherein, for each electrode arrangement, the electrode arrangement comprises no more than 12 electrodes.

9. The ion trap device of any one of claims 1 to 8, wherein, for each electrode arrangement, the electrode arrangement comprises a single electrode.

10. The ion trap device of any one of claims 1 to 9, wherein the plurality of electrode arrangements comprises one or more sets of electrode arrangements wherein:

each set of electrode arrangements comprises a shared return line portion for providing a reference voltage for the return line portion of each electrode arrangement in said set of electrode arrangements; and

for each set of electrode arrangements, the return line portion (230, 330, 430, 530) of each electrode arrangement in the set of electrode arrangements connects between the capacitance arrangement of said electrode arrangement and the shared return line (301, 401).

11. The ion trap device of claim 10, wherein:

each set of electrode arrangements comprises one or more shared signal line portions for carrying a signal voltage to a respective signal line portion;

for each set of electrode arrangements, each signal line portion (220, 320, 420, 520) of each electrode arrangement in the set of electrode arrangements connects between the capacitance arrangement of said electrode arrangement and a respective one of the one or more shared signal line portions; and

the shared return line portion and each shared signal line portion run alongside proximate to one another for a majority of the length of the shared return line portion.

12. The ion trap device of claim 10 or 11, wherein:

the one or more sets of electrode arrangements comprises two or more sets (551, 552) of electrode arrangements (500A, 500B, 500C, 500D);

the plurality of electrode arrangements comprises one or more groups (550) of electrode arrangements, wherein each group of electrode arrangement comprises two or more of the sets (551, 552) of electrode arrangements;

each group of electrode arrangements comprises a common return line portion (591) for providing a reference voltage for the shared return line portion (501A, 501B) of each set of electrode arrangements in said group of electrode arrangements; and

for each group of electrode arrangements, the shared return line portion, of each set of electrode arrangements in the group of electrode arrangements, connects to the common return line portion of said group of electrode arrangements.

13. The ion trap device of any one of claims 1 to 12, comprising a multilayer stack, wherein, for each electrode arrangement, the return line portion and each signal line portion is located in the multilayer stack.

14. The ion trap device of claim 13, wherein, for each electrode arrangement, the return line portion is provided in a different layer of the multilayer stack with respect to the one or more signal line portions.

15. The ion trap device of claim 13, wherein, for each electrode arrangement, the return line portion is provided in a same layer of the multilayer stack as the one or more signal line portions.

16. The ion trap device of any of claims 1 to 15, wherein, for each electrode arrangement, the majority of the length of the return line portion is no less than 90% of the length of the return line portion.

17. The ion trap device of any of claims 1 to 16, wherein each electrode arrangement further comprises one or more switching devices for controlling a connection between each signal line portion and the electrode.

18. The ion trap device of any of claims 1 to 17, further comprising at least one signal generator (20, 61, 62, 71, 72) for generating the respective signal voltage for each signal line portion of each electrode arrangement.

FIG. 1

FIG. 2

FIG. 3

FIG. 4

FIG. 5

FIG. 6

FIG. 7

810    811
820    821
830    831
840    841

851

852

812    822    832    842

## FIG. 8

910    911
920    921

951

952

912    913    922    923

## FIG. 9

1010    1011

1051

1052

1012    1013    1014    1015

## FIG. 10

Europäisches
Patentamt

European
Patent Office

Office européen
des brevets

## EUROPEAN SEARCH REPORT

**Application Number**

EP 24 16 9676

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/322188 A1 (YOUNGNER DANIEL [US]) 3 November 2016 (2016-11-03) | 1-16,18 | INV. G06N10/40 |
| Y | * paragraphs [0038] - [0054]; figures 1-3 * | 17 | |
| Y | EP 4 310 863 A1 (INFINEON TECHNOLOGIES AUSTRIA AG [AT]) 24 January 2024 (2024-01-24) * paragraphs [0041] - [0046]; figures 3C, 3D * | 17 | |
| A | CN 220 189 256 U (HUAYI BOAO BEIJING QUANTUM TECH CO LTD) 15 December 2023 (2023-12-15) * figure 1 * | 1-18 | |

**TECHNICAL FIELDS SEARCHED (IPC)**

G21K
H01J
G06N

The present search report has been drawn up for all claims

| Place of search | Date of completion of the search | Examiner |
|---|---|---|
| Munich | 4 July 2024 | Sewtz, Michael |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 16 9676

This annex lists the patent family members relating to the patent documents cited in the above-mentioned European search report.
The members are as contained in the European Patent Office EDP file on
The European Patent Office is in no way liable for these particulars which are merely given for the purpose of information.

04-07-2024

| Patent document cited in search report | | Publication date | Patent family member(s) | | Publication date |
|---|---|---|---|---|---|
| US 2016322188 | A1 | 03-11-2016 | EP | 3088354 A1 | 02-11-2016 |
| | | | US | 2016322188 A1 | 03-11-2016 |
| | | | US | 2017301501 A1 | 19-10-2017 |
| | | | US | 2018204701 A1 | 19-07-2018 |
| | | | US | 2020027684 A1 | 23-01-2020 |
| | | | US | 2020227226 A1 | 16-07-2020 |
| EP 4310863 | A1 | 24-01-2024 | CN | 117438127 A | 23-01-2024 |
| | | | EP | 4310863 A1 | 24-01-2024 |
| | | | US | 2024030019 A1 | 25-01-2024 |
| | | | US | 2024213015 A1 | 27-06-2024 |
| CN 220189256 | U | 15-12-2023 | NONE | | |

EPO FORM P0459

For more details about this annex : see Official Journal of the European Patent Office, No. 12/82